(19) Europäisches Patentamt / European Patent Office / Office européen des brevets

(11) **EP 4 235 601 A2**

(12) **DEMANDE DE BREVET EUROPEEN**

(43) Date de publication:
**30.08.2023 Bulletin 2023/35**

(21) Numéro de dépôt: **23180840.3**

(22) Date de dépôt: **18.07.2019**

(51) Classification Internationale des Brevets (IPC):
*G06V 40/13* $^{(2022.01)}$

(52) Classification Coopérative des Brevets (CPC):
**G02B 3/0056; G02B 5/201; G06V 10/143; G06V 10/147; G06V 40/1318; H01L 27/14623; H01L 27/14627; H01L 27/14685;** G02B 5/003; G02B 5/005; G02B 2207/123

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.07.2018 FR 1856709**

(62) Numéro(s) de document de la (des) demande(s) initiale(s) en application de l'article 76 CBE:
**19740009.6 / 3 824 326**

(71) Demandeur: **ISORG**
**87068 Limoges Cedex 3 (FR)**

(72) Inventeurs:
• **SCHWARTZ, Wilfrid**
**38000 GRENOBLE (FR)**

• **CHABLE, Quentin**
**38000 GRENOBLE (FR)**
• **PUSZKA, Agathe**
**38000 GRENOBLE (FR)**
• **BOUTHINON, Benjamin**
**38000 GRENOBLE (FR)**

(74) Mandataire: **Cabinet Beaumont**
**4, Place Robert Schuman**
**B.P. 1529**
**38025 Grenoble Cedex 1 (FR)**

Remarques:
Cette demande a été déposée le 22-06-2023 comme demande divisionnaire de la demande mentionnée sous le code INID 62.

(54) **SYSTEME OPTIQUE ET SON PROCEDE DE FABRICATION**

(57) La présente description concerne un procédé de fabrication d'un système optique (5) comprenant une couche (24) comprenant des trous traversants ou partiellement traversants (26) et recouverte d'une matrice d'éléments optiques de taille micrométrique (14). Le système optique comprend une face (22) destinée à recevoir un premier rayonnement. Le procédé comprend l'exposition d'un film (24), du même matériau que la couche ou d'un matériau différent de celui de la couche, à un deuxième rayonnement au travers de la matrice d'éléments optiques de taille micrométrique (14), ledit matériau étant photosensible au deuxième rayonnement ou usinable par le deuxième rayonnement et le retrait des parties du film exposées ou non exposées au deuxième rayonnement pour délimiter les trous (26) traversant totalement ou partiellement ladite couche.

Fig 1

EP 4 235 601 A2

**Description**

La présente demande de brevet revendique la priorité de la demande de brevet français FR18/56709 qui sera considérée comme faisant partie intégrante de la présente description.

Domaine technique

La présente description concerne les systèmes optiques et leurs procédés de fabrication.

Technique antérieure

Un système optique est un ensemble d'éléments optiques, tels que des miroirs, des lentilles, des réseaux de diffraction, etc. permettant de modifier la trajectoire des rayons lumineux ou les propriétés de la lumière. Un exemple d'application d'un système optique concerne un système d'acquisition d'images dans lequel le système optique est interposé entre la partie sensible d'un capteur d'images et l'objet à imager, et qui permet de former une image nette de l'objet à imager sur la partie sensible du capteur d'images. Un autre exemple d'application consiste à coupler le système optique à un photodétecteur unique, tel qu'une photodiode, afin de contrôler la lumière collectée par le photodétecteur. Un autre exemple d'application concerne un système d'affichage ou de projection dans lequel le système optique recouvre une source lumineuse, par exemple un écran d'affichage, et permet de modifier le rayonnement émis par la source lumineuse, par exemple collimater le rayonnement émis par chaque pixel d'affichage.

Toutefois, dans certains cas, il n'est pas possible d'utiliser un système optique classique. Par exemple, dans le cas d'un système d'acquisition d'images, il peut ne pas être possible de placer un système optique classique entre la partie sensible du capteur d'images et l'objet à imager. C'est le cas notamment lorsque le capteur d'images occupe une surface importante, supérieure au centimètre carré et que la distance entre l'objet à imager et la partie sensible du capteur d'images est inférieure au centimètre.

Il faudrait alors placer l'objet à imager au plus près du capteur d'images pour que l'image qui se forme sur la partie sensible du capteur d'images soit suffisamment nette. Toutefois, une distance peut être présente entre l'objet et le capteur d'images de sorte que la netteté de l'image qui se forme sur la partie sensible du capteur d'images peut ne pas être suffisante pour certaines applications, par exemple pour la capture d'empreintes digitales.

Pour accroître la netteté de l'image acquise par le capteur d'images d'un système d'acquisition d'images en l'absence de système optique complexe, une possibilité consiste à recouvrir le capteur d'images d'un système optique de structure simple jouant le rôle d'un filtre angulaire, comprenant une couche opaque traversée par des ouvertures, et recouverte d'une matrice d'éléments optiques de taille micrométrique, par exemple une matrice de lentilles de taille micrométrique, ou microlentilles, un réseau de microlentilles à gradient d'indice de taille micrométrique, ou une matrice de réseaux de diffraction de taille micrométrique, chaque élément optique de taille micrométrique étant associé à une ouverture de la couche à ouvertures.

Un exemple de procédé de fabrication d'un tel système optique comprend la fabrication de la couche à ouvertures, la fabrication des éléments optiques de taille micrométrique et le positionnement des éléments optiques de taille micrométrique par rapport à la couche à ouvertures. L'étape de positionnement des éléments optiques de taille micrométrique par rapport à la couche à ouvertures requiert l'utilisation d'outils d'alignement. Ces outils d'alignement existent mais engendrent un coût important pour la fabrication de ces systèmes optiques et surtout ne permettent pas de produire ces systèmes optiques à très grande échelle. En outre, de par l'utilisation de matériaux organiques, la couche à ouvertures et/ou les éléments optiques de taille micrométrique peuvent comprendre des déformations, résultant d'effets thermiques et/ou mécaniques, de sorte que l'alignement correct de chaque élément optique de taille micrométrique avec l'ouverture correspondante de la couche à ouvertures peut ne pas être possible pour la totalité des éléments optiques de taille micrométrique.

Résumé de l'invention

Un objet d'un mode de réalisation est de pallier, en totalité ou en partie, les contraintes liées à la fabrication des systèmes optiques comprenant une couche à ouvertures et une matrice d'éléments optiques de taille micrométrique et de leurs procédés de fabrication décrits précédemment.

Un objet d'un mode de réalisation est que le positionnement des éléments optiques de taille micrométrique par rapport aux ouvertures de la couche à ouvertures puisse être réalisé avec une précision suffisante.

Un autre objet d'un mode de réalisation est que le procédé de fabrication du système optique puisse être mis en oeuvre à une échelle industrielle.

Dans ce but, un mode de réalisation prévoit un procédé de fabrication d'un système optique comprenant une couche comprenant des trous traversants ou partiellement traversants et recouverte d'une matrice d'éléments optiques de taille micrométrique. Le système optique comprend une face destinée à recevoir un premier rayonnement. Le procédé comprend l'exposition d'un film, du même matériau que la couche ou d'un matériau différent de celui de la couche, à un deuxième rayonnement au travers de la matrice d'éléments optiques de taille micrométrique, ledit matériau étant photosensible au deuxième rayonnement ou usinable par le deuxième rayonnement et le retrait des parties du film exposées ou non exposées au deuxième rayonnement pour délimiter les trous traversant totalement ou partiellement ladite couche.

Selon un mode de réalisation, le film est en une résine photosensible au deuxième rayonnement.

Selon un mode de réalisation, la couche est en une résine photosensible positive au deuxième rayonnement, les parties retirées du film étant les parties exposées au deuxième rayonnement.

Selon un mode de réalisation, le film est en une résine photosensible négative au deuxième rayonnement, les parties retirées du film étant les parties non exposées au deuxième rayonnement.

Selon un mode de réalisation, le procédé comprend l'usinage de la couche par un faisceau laser.

Selon un mode de réalisation, le système optique forme un filtre angulaire configuré pour bloquer les rayons dudit premier rayonnement dont l'incidence par rapport à une direction orthogonale à la face est dans au moins une première plage d'incidences et à laisser passer des rayons dudit premier rayonnement dont l'incidence par rapport à une direction orthogonale à la face est dans au moins une deuxième plage d'incidences distincte de ladite au moins une première plage d'incidences.

Selon un mode de réalisation, le premier rayonnement est différent du deuxième rayonnement.

Selon un mode de réalisation, le premier rayonnement est dans le domaine visible et/ou dans le domaine infrarouge.

Selon un mode de réalisation, le deuxième rayonnement est dans le domaine visible et/ou dans le domaine ultraviolet.

Selon un mode de réalisation, le procédé comprend, à l'étape d'exposition, la mise en contact de la matrice d'éléments optiques de taille micrométrique avec un matériau, différent de l'air, d'indice de réfraction différent de celui des éléments optiques de taille micrométrique.

Selon un mode de réalisation, la fabrication du système optique est réalisée bobine à bobine.

Selon un mode de réalisation, le procédé comprend après la formation des trous, le remplissage des trous par un matériau de collage et la fixation de la couche comprenant les trous à un dispositif par l'intermédiaire du matériau de collage.

Selon un mode de réalisation, le deuxième rayonnement est collimaté.

Selon un mode de réalisation, le deuxième rayonnement a un angle de divergence supérieur à 1°.

Un mode de réalisation prévoit également un système optique comprenant une face destinée à recevoir un premier rayonnement, une couche comprenant des trous traversants ou partiellement traversants et recouverte d'une matrice d'éléments optiques de taille micrométrique. La couche est en un matériau ou les trous sont remplis dudit matériau, ledit matériau étant photosensible à un deuxième rayonnement ou usinable par le deuxième rayonnement.

Selon un mode de réalisation, la couche est opaque au premier rayonnement, le système étant configuré pour bloquer les rayons dudit premier rayonnement dont l'incidence par rapport à une direction orthogonale à la face est dans au moins une première plage d'incidences et à laisser passer des rayons dudit premier rayonnement dont l'incidence par rapport à une direction orthogonale à la face est dans au moins une deuxième plage d'incidences distincte de ladite au moins une première plage d'incidences.

Selon un mode de réalisation, le matériau est une résine photosensible au deuxième rayonnement.

Selon un mode de réalisation, le système comprend autant d'éléments optiques de taille micrométrique que de trous, le pas entre les éléments optiques de taille micrométrique étant le même que le pas entre les trous.

Selon un mode de réalisation, pour chaque trou, le rapport entre la hauteur du trou, mesurée perpendiculairement à la face, et la largeur du trou, mesurée parallèlement à la face, varie de 1 à 10.

Selon un mode de réalisation, les trous sont agencés en rangées et en colonnes, le pas entre des trous adjacents d'une même rangée ou d'une même colonne variant de 1 $\mu$m à 100 $\mu$m.

Selon un mode de réalisation, la hauteur de chaque trou, mesurée selon une direction orthogonale à la face, varie de 1 $\mu$m à 800 $\mu$m, notamment de 10 $\mu$m à 800 $\mu$m ou de 1 $\mu$m à 100 $\mu$m.

Selon un mode de réalisation, la largeur de chaque trou, mesurée parallèlement à la face, varie de 0,1 $\mu$m à 100 $\mu$m.

Selon un mode de réalisation, le système comprend un empilement de ladite couche comprenant lesdits trous traversants ou partiellement traversants et d'une couche supplémentaire comprenant des trous supplémentaires traversants ou partiellement traversants alignés avec lesdits trous.

Un mode de réalisation prévoit également un système d'acquisition d'images comprenant un capteur d'images et un système optique, tel que défini précédemment, recouvrant le capteur d'images et formant un filtre angulaire.

Selon un mode de réalisation, le capteur d'images comprend une matrice de photodétecteurs, le pas entre les photodétecteurs étant égal, supérieur ou inférieur au pas entre les trous.

Selon un mode de réalisation, le système optique comprend une couche auxiliaire jouant le rôle de couche de protection du capteur d'images.

Selon un mode de réalisation, le capteur d'images est au moins en partie réalisé en matériaux organiques, et le système optique comprend un film étanche à l'eau et/ou à l'oxygène.

Un mode de réalisation prévoit également un système d'éclairage ou d'affichage comprenant une source lumineuse et un système optique, tel que défini précédemment, recouvrant la source lumineuse.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un mode de réalisation d'un système optique comprenant une couche à ouvertures recouverte d'un réseau de microlentilles ;

la figure 2 est une vue de dessus de la couche à ouvertures du système optique représenté en figure 1 ;

la figure 3 est une vue en coupe, partielle et schématique, d'une variante du système optique représenté en figure 1 ;

la figure 4 est une vue en coupe, partielle et schématique, d'une autre variante du système optique représenté en figure 1 ;

la figure 5 est une vue en coupe, partielle et schématique, d'un mode de réalisation d'un système d'acquisition d'images ;

la figure 6 est une vue en coupe, partielle et schématique, d'un mode de réalisation d'un système d'éclairage ou de projection ;

la figure 7 est une vue en coupe, partielle et schématique, d'un autre mode de réalisation d'un système d'éclairage ;

la figure 8 est une vue en coupe, partielle et schématique, de la structure obtenue à une étape d'un mode de réalisation d'un procédé de fabrication du système optique représenté sur les figures 1 et 2 ;

la figure 9 est une vue en coupe, partielle et schématique, de la structure obtenue à une autre étape d'un mode de réalisation d'un procédé de fabrication du système optique représenté sur les figures 1 et 2 ;

la figure 10 est une vue en coupe, partielle et schématique, de la structure obtenue à une autre étape d'un mode de réalisation d'un procédé de fabrication du système optique représenté sur les figures 1 et 2 ;

la figure 11 est une vue en coupe, partielle et schématique, de la structure obtenue à une autre étape d'un mode de réalisation d'un procédé de fabrication du système optique représenté sur les figures 1 et 2 ;

la figure 12 est une vue en coupe, partielle et schématique, de la structure obtenue à une autre étape d'un mode de réalisation d'un procédé de fabrication du système optique représenté sur les figures 1 et 2 ;

la figure 13 est une vue en coupe, partielle et schématique, de la structure obtenue à une étape d'un autre mode de réalisation d'un procédé de fabrication du système optique représenté sur les figures 1 et 2 ; et

la figure 14 est une vue en coupe, partielle et schématique, de la structure obtenue à une autre étape d'un autre mode de réalisation d'un procédé de fabrication du système optique représenté sur les figures 1 et 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la structure d'un capteur d'images est bien connue de l'homme du métier et n'est pas décrite en détail par la suite.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un système optique dans une position normale d'utilisation.

Sauf précision contraire, les expressions "environ", "approximativement", "sensiblement", et "de l'ordre de" signifient à 10 % près, de préférence à 5 % près.

Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %. Selon un mode de réalisation, pour un même système optique, tous les éléments du système optique qui sont opaques à un rayonnement ont une transmittance qui est inférieure à la moitié, de préférence inférieure au cinquième, plus préférentiellement inférieure au dixième, de la transmittance la plus faible des éléments du système optique transparents audit rayonnement. Dans la suite de la description, on appelle "rayonnement utile" le rayonnement électromagnétique traversant le système optique en fonctionnement. Dans la suite de la description, on appelle "élément optique de taille micrométrique" un élément optique formé sur une face d'un support dont la dimension maximale, mesurée parallèlement à ladite face, est supérieure à 1 $\mu$m et inférieure à 1 mm. Dans la suite de la description, un film ou une couche est dit étanche à l'oxygène lorsque la perméabilité du film ou de la couche à l'oxygène à 40°C est inférieure à $1.10^{-1}$cm$^3$/(m$^2$*jour). La perméabilité à l'oxygène peut être mesurée selon la méthode ASTM D3985 intitulée "Standard Test Method for Oxygen Gas Transmission Rate Through Plastic Film and Sheeting Using a Coulometric Sensor". Dans la suite de la description, un film ou une couche est dit étanche à l'eau lorsque la perméabilité du film ou de la couche à l'eau à 40°C est inférieure à $1.10^{-1}$g/(m$^2$*jour). La perméabilité à l'eau peut être mesurée selon la méthode ASTM F1249 intitulée "Standard Test Method for Water Vapor Transmission Rate Through Plastic Film and Sheeting Using a Modulated Infrared Sensor".

Des modes de réalisation de systèmes optiques vont maintenant être décrits pour des systèmes optiques comprenant une matrice d'éléments optiques à taille micrométrique dans le cas où chaque élément optique à taille micrométrique correspond à une lentille à taille micrométrique, ou microlentille. Toutefois, il est clair que ces modes de réalisation peuvent également être mis en oeuvre avec d'autres types d'éléments optiques de taille micrométrique, chaque élément optique de taille micrométrique pouvant correspondre à une lentille de Fresnel de taille micrométrique, à une lentille à gradient d'indice de taille micrométrique ou à un réseau de diffraction de taille micrométrique.

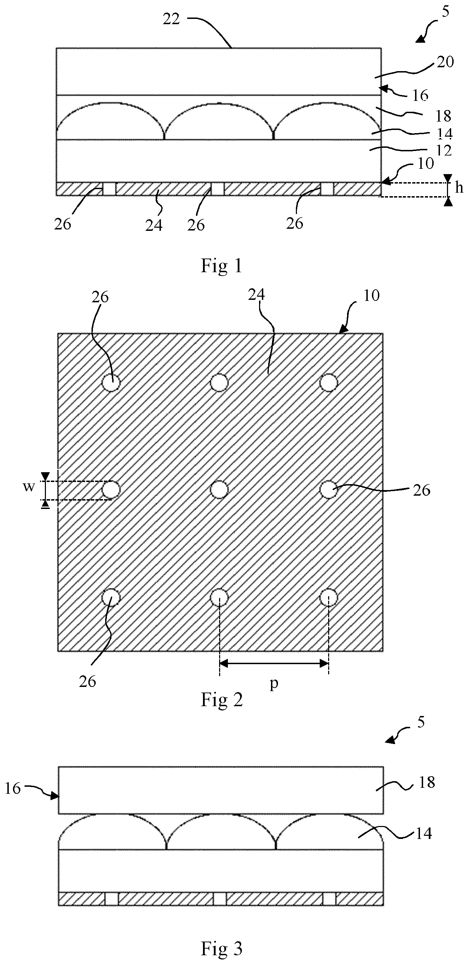

La figure 1 est une vue en coupe, partielle et schématique d'un mode de réalisation d'un système optique 5. Le système optique 5, comprend, du bas vers le haut en figure 1 :

- une couche à ouvertures 10 ;

- une couche intermédiaire 12 recouvrant la couche à ouvertures 10, la couche intermédiaire 12 pouvant ne pas être présente ;

- une matrice d'éléments optiques 14 de taille micrométrique, par exemple une matrice de microlentilles 14 recouvrant la couche intermédiaire 12, la couche intermédiaire 12 et la matrice de microlentilles 14 pouvant correspondre à une structure monolithique ;

- un revêtement 16 recouvrant la matrice de microlentilles 14 et comprenant par exemple un empilement de plusieurs couches, par exemple deux couches 18 et 20, et comprenant une face supérieure 22, le revêtement 16 pouvant ne pas être présent, la face supérieure 22 correspondant alors à la face supérieure de la matrice de microlentilles 14.

La figure 2 est une vue de dessus de la couche à ouvertures 10 représentée en figure 1. Dans le présent mode de réalisation, la couche à ouvertures 10 comprend une couche opaque 24 traversé par des trous 26, appelés également ouvertures. De préférence, les trous 26 sont traversants dans la mesure où ils s'étendent sur la totalité de l'épaisseur de la couche 24. Selon un autre mode de réalisation, les trous 26 peuvent ne s'étendre que sur une partie de l'épaisseur de la couche opaque 24, une portion résiduelle de la couche opaque 24 demeurant au fond des trous 26. Toutefois, dans ce cas, l'épaisseur de la portion résiduelle de la couche opaque 24 au fond du trou 26 est suffisamment faible pour que l'ensemble comprenant le trou 26, éventuellement rempli, et la portion résiduelle de la couche opaque 24 au fond du trou 26 puisse être considéré comme transparent au rayonnement utile. On appelle "h" l'épaisseur de la couche 24. La couche 24 est opaque à la totalité ou à une partie du spectre du rayonnement 42. La couche 24 peut être opaque au rayonnement utile utilisé en fonctionnement, par exemple absorbante et/ou réfléchissante par rapport au rayonnement utile. Selon un mode de réalisation, la couche 24 est absorbante dans le visible ou une partie du visible et/ou le proche infrarouge et/ou l'infrarouge.

En figure 2, les trous 26 sont représentés avec une section droite circulaire. De façon générale, la section droite des trous 26 dans la vue de dessus peut être quelconque, par exemple annulaire, circulaire, ovale ou polygonale, notamment triangulaire, carrée ou rectangulaire selon le procédé de fabrication utilisé. En outre, sur la figure 1, les trous 26 sont représentés avec une section droite constante sur toute l'épaisseur de la couche opaque 24. Toutefois, la section droite de chaque trou 26 peut varier sur l'épaisseur de la couche opaque 24. Dans le cas où les trous 26 sont formés par un procédé comprenant des étapes de photolithographie, la forme des trous peut être ajustée par les paramètres des procédés tels que la dose d'exposition et le temps de développement ainsi que par la forme des microlentilles.

Selon un mode de réalisation, les trous 26 sont disposés en rangées et en colonnes. Les trous 26 peuvent avoir sensiblement les mêmes dimensions. On appelle "w" la largeur d'un trou 26 mesurée selon la direction des rangées ou des colonnes. La largeur w correspond au diamètre du trou 26 dans le cas d'un trou de section droite circulaire. Selon un mode de réalisation, les trous 26 sont disposés régulièrement selon les rangées et selon les colonnes. On appelle "p" le pas de répétition des trous 26, c'est-à-dire la distance en vue de dessus des centres de deux trous 26 successifs d'une rangée ou d'une colonne.

La couche à ouvertures 10 laisse seulement passer les rayons du rayonnement utile incident dont l'incidence par rapport à la face supérieure de la couche à ouvertures 10 est inférieure à un angle d'incidence maximale $\alpha$, qui est défini par la relation (1) suivante :

$$\tan \alpha = w/h \qquad\qquad\qquad (1)$$

Le rapport h/w peut varier de 1 à 10, voire est supérieur à 10. Le pas p peut varier de 1 $\mu$m à 100 $\mu$m, par exemple égal à environ 15 $\mu$m. La hauteur h peut varier de 0,1 $\mu$m à 1 mm, notamment de 1 $\mu$m à 800 $\mu$m, de préférence de 10 $\mu$m à 130 $\mu$m ou de 1 $\mu$m à 100 $\mu$m. La largeur w peut varier de 0,1 $\mu$m à 100 $\mu$m, par exemple égale à environ 2 $\mu$m. Les trous 26 peuvent avoir tous la même largeur w. A titre de variante, les trous 26 peuvent avoir des largeurs w différentes.

La figure 3 est une vue en coupe d'une variante du système optique 5 représenté en figure 1 dans laquelle le revêtement 16 comprend seulement la couche 18 qui correspond à un film appliqué contre la matrice de microlentilles 14. Dans ce cas, la zone de contact entre la couche 18 et les microlentilles 14 peut être réduite, par exemple limitée aux sommets des microlentilles 14.

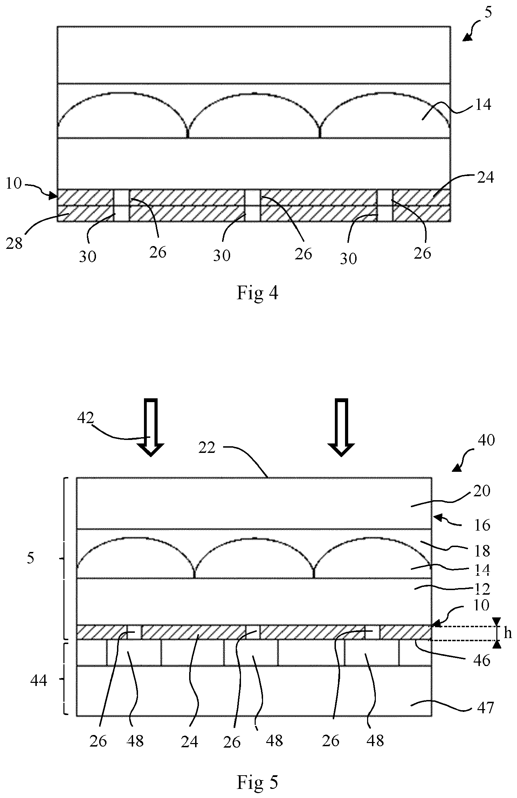

La figure 4 est une vue en coupe d'une autre variante du système optique 5 représenté en figure 1 dans laquelle la couche à ouvertures 10 comprend une couche opaque 28 supplémentaire recouvrant la couche opaque 24, du côté de la couche opaque 24 opposé aux microlentilles 14, et traversée par des trous 30 situés dans le prolongement des trous 26. Une couche intermédiaire, transparente au rayonnement utile, peut être interposée entre les couches opaques 24 et 28. De façon générale, la couche à ouvertures 10 peut comprendre un empilement de plus de deux couches opaques, chaque couche opaque étant traversée par des trous, les couches opaques de chaque paire de couches opaques adjacentes étant espacées ou non par une ou des couches transparentes.

Selon un mode de réalisation, la couche 24 est en totalité en un matériau absorbant et/ou réfléchissant au moins pour les longueurs d'onde à filtrer angulairement du rayonnement utile.

Selon un mode de réalisation, la couche 24 est en une résine photosensible positive, c'est-à-dire une résine photosensible pour laquelle la partie de la couche de résine exposée à un rayonnement devient soluble à un révélateur et où la partie de la couche de résine photosensible qui n'est pas exposée au rayonnement reste insoluble dans le révélateur. La couche opaque 24 peut être en résine colorée, par exemple une résine DNQ-Novolaque colorée ou noire ou une résine photosensible DUV (sigle anglais pour Deep Ultraviolet). Les résines DNQ-Novolaque sont basées sur un mélange de diazonaphtoquinone (DNQ) et d'une résine novolaque (résine de phénolformaldéhyde). Les résines DUV peuvent comprendre des polymères basés sur les polyhydroxystyrènes.

Selon un autre mode de réalisation, la couche 24 est en une résine photosensible négative, c'est-à-dire une résine photosensible pour laquelle la partie de la couche de résine exposée à un rayonnement devient insoluble à un révélateur et où la partie de la couche de résine photosensible qui n'est pas exposée au rayonnement reste soluble dans le révélateur. Des exemples de résines photosensibles négatives sont des résines polymères à base d'epoxy, par exemple la résine commercialisée sous l'appellation SU-8, des résines acrylates et des polymères thiol-ène hors stoechiométrie (OSTE, sigle anglais pour Off-Stoichiometry thiol-enes polymer).

Selon un autre mode de réalisation, la couche 24 est en un matériau usinable au laser, c'est-à-dire un matériau susceptible de se dégrader sous l'action d'un rayonnement laser. Des exemples de matériaux usinables par laser sont le graphite, des matériaux plastiques tels que le poly(méthacrylate de méthyle) (PMMA, sigle anglais pour poly(methyl methacrylate)), l'acrylonitrile butadiène styrène (ABS) ou des films plastiques teintés comme le poly(téréphtalate d'éthylène) (PET, sigle anglais polyethylene terephthalate), le poly(naphtalate d'éthylène) (PEN, sigle anglais pour Polyethylene naphthalate), les polymères d'oléfine cyclique (COP, sigle anglais pour Cyclo Olefin Polymer) et les polyimides (PI).

En outre, à titre d'exemple, la couche 24 peut être en une résine noire absorbante dans le domaine visible et/ou le proche infrarouge. Selon un autre exemple, la couche opaque 24 peut en outre être en une résine colorée absorbant la lumière visible d'une couleur donnée, par exemple la lumière bleue, verte ou cyan. Ceci peut être le cas lorsque le système optique 5 est utilisé avec un capteur d'images qui est sensible seulement à la lumière de couleur donnée. Ceci peut en outre être le cas lorsque le système optique 5 est utilisé avec un capteur d'images qui est sensible à la lumière visible et qu'un filtre de la couleur donnée est interposé entre le capteur d'image et l'objet à détecter, par exemple entre la couche à ouvertures 10 et la couche intermédiaire 12.

Lorsque la couche à ouvertures 10 est formée d'un empilement d'au moins deux couches opaques 24, 28, chaque couche opaque peut être dans l'un des matériaux cités précédemment, les couches opaques pouvant être dans des matériaux différents.

Les trous 26, 30 peuvent être remplis d'air ou remplis d'un matériau au moins partiellement transparent au rayonnement utile, par exemple du polydiméthylsiloxane (PDMS). A titre de variante, les trous 26, 30 peuvent être remplis par un matériau partiellement absorbant afin de filtrer en longueur d'onde les rayons du rayonnement utile. Le système optique 5 peut alors jouer en outre le rôle d'un filtre en longueur d'onde. Ceci permet de réduire l'épaisseur du système 5 par rapport au cas où un filtre coloré distinct du système optique 5 serait présent. Le matériau de remplissage partiellement absorbant peut être une résine coloré ou un matériau plastique coloré comme le PDMS.

Le matériau de remplissage des trous 26, 30 peut être sélectionné afin d'avoir une adaptation d'indice de réfraction avec la couche intermédiaire 12 en contact avec la couche à ouvertures 10 ou bien pour rigidifier la structure et améliorer la tenue mécanique de la couche à ouvertures 10. En outre, le matériau de remplissage peut aussi être un matériau adhésif liquide ou solide permettant l'assemblage du système optique 5 sur un autre dispositif, par exemple un capteur d'images. Le matériau de remplissage peut être aussi une colle époxy ou acrylate servant à l'encapsulation du dispositif sur une face duquel repose le système optique, par exemple un capteur d'images, en considérant que la couche 12 est un film d'encapsulation. Dans ce cas, la colle remplit les trous 26 et se trouve au contact de la face du capteur d'images. La colle permet également de laminer le système optique sur le capteur d'images.

La couche intermédiaire 12, qui peut ne pas être présente, est au moins partiellement transparente au rayonnement utile. La couche intermédiaire 12 peut être en un polymère transparent, notamment en PET, en PMMA, en COP, en PEN, en polyimide, en une couche de polymères diélectriques ou inorganiques (SiN, SiO$_2$), ou en une couche de verre mince. Comme cela a été indiqué précédemment, la couche 12 et la matrice de microlentilles 14 peuvent correspondre à une structure monolithique. En outre, la couche 12 peut correspondre à une couche de protection du dispositif, par exemple un capteur d'images, sur lequel le système optique 5 est fixé. Si le capteur d'images est en matériaux organiques, la couche 12 peut correspondre à un film barrière étanche à l'eau et l'oxygène protégeant les matériaux organiques. A titre d'exemple, cette couche de protection peut correspondre un dépôt de SiN de l'ordre de 1 $\mu$m sur la face d'un film de PET, PEN, COP, et/ou PI en contact de la couche à ouvertures 10.

Selon un mode de réalisation, il y a autant de microlentilles 14 que de trous 26. De préférence, la disposition des microlentilles 14 suit la disposition des trous 26. En particulier, le pas entre les centres optiques de microlentilles 14 adjacentes est le même que le pas p des trous 26 décrit précédemment.

Selon un autre mode de réalisation, les microlentilles 14 peuvent être, en vue de dessus, à base polygonale, notamment carrée, rectangulaire, pentagonale ou hexagonale. De préférence, les microlentilles 14 sont, en vue de dessus, sensiblement jointives. Selon un autre mode de réalisation, les microlentilles 14 peuvent être, en vue de dessus, à base circulaire ou ovale.

De préférence, les plans focaux des microlentilles 14 sont confondus. Les plans focaux des microlentilles 14 peuvent être situés sensiblement dans l'épaisseur de la couche opaque 24 ou à distance de la couche opaque 24. Selon un mode de réalisation, les microlentilles 14 ont toutes la même forme. Selon un autre mode de réalisation, les microlentilles 14 ont des formes différentes. Les microlentilles 14 peuvent être réalisées en silice, en PMMA, en une résine photosensible positive, en PET, en PEN, en COP, en PDMS/silicone, ou en résine époxy. Les microlentilles 14 peuvent être formées par fluage de blocs d'une résine photosensible. Les microlentilles 14 peuvent en outre être formées par moulage sur une couche de PET, PEN, COP, PDMS/silicone ou résine epoxy.

Le revêtement 16 est au moins partiellement transparent au rayonnement utile. Le revêtement 16 peut avoir une épaisseur maximale comprise en 0,1 $\mu$m et 10 mm. La face supérieure 22 peut être sensiblement plane ou avoir une forme courbe.

Selon un mode de réalisation, la couche 18 est une couche qui épouse la forme des microlentilles 14. La couche 18 peut être obtenue à partir d'un adhésif optiquement transparent (OCA, sigle anglais pour Optically Clear Adhesive), notamment un adhésif optiquement transparent liquide (LOCA, sigle anglais pour Liquid Optically Clear Adhesive), ou un matériau à bas indice de réfraction, ou une colle epoxy / acrylate, ou à un film d'un gaz ou d'un mélange gazeux, par exemple de l'air. De préférence, lorsque la couche 18 épouse la forme des microlentilles 14, la couche 18 est en un matériau ayant un bas indice de réfraction, inférieur à celui du matériau des microlentilles 14. La couche 18 peut être en un matériau de remplissage qui est un matériau transparent non adhésif. Selon un autre mode de réalisation, la couche 18 correspond à un film qui est appliqué contre la matrice de microlentilles 14, par exemple un film OCA.

Dans ce cas, la zone de contact entre la couche 18 et les microlentilles 14 peut être réduite, par exemple limitée aux sommets des microlentilles. La couche 18 peut être alors composée d'un matériau ayant un indice de réfraction plus élevé que dans le cas où la couche 18 épouse les microlentilles 14. Selon un mode de réalisation, la couche 20 peut être en l'un des matériaux indiqués précédemment pour la couche 18. La couche 20 peut ne pas être présente. L'épaisseur de la couche 20 est comprise entre 1 $\mu$m et 100 $\mu$m.

Un exemple d'application du système optique va maintenant être décrit pour un filtre angulaire d'un système d'acquisition d'images.

La figure 5 est une vue en coupe, partielle et schématique, d'un mode de réalisation d'un système d'acquisition d'images 40 recevant un rayonnement 42. Le système d'acquisition d'images 40, comprend, du bas vers le haut en figure 5 :

- un capteur d'images 44 ayant une face supérieure 46 ; et

- le système optique 5 formant un filtre angulaire et recouvrant la face 46.

Le capteur d'images 44 comprend un support 47 et une matrice de capteurs de photons 48, également appelés photodétecteurs, disposés entre le support 47 et le système optique 5. Les photodétecteurs 48 peuvent être recouverts d'un revêtement de protection transparent, non représenté. Le capteur d'images 44 comprend, en outre, des pistes conductrices et des éléments de commutation, notamment des transistors, non représentés, permettant la sélection des photodétecteurs 48. En figure 5, les photodétecteurs sont représentés espacés d'un pas sensiblement constant. Les photodétecteurs 48 peuvent être réalisés en matériaux organiques. Les photodétecteurs 48 peuvent correspondre à des photodiodes organiques (OPD, de l'anglais Organic Photodiode), à des photorésistances organiques, à des photodiodes en silicium amorphe associées à une matrice de transistors CMOS. La surface du capteur d'images 44 en regard du système optique 5 et contenant les photodétecteurs 48 est supérieure à 1 cm$^2$, de préférence supérieure à 5 cm$^2$, plus préférentiellement supérieure à 10 cm$^2$, en particulier supérieure à 20 cm$^2$. La face supérieure 46 du capteur d'images 44 peut être sensiblement plane.

Selon un mode de réalisation, chaque photodétecteur 48 est adapté à détecter un rayonnement électromagnétique dans une plage de longueurs d'ondes comprises entre 400 nm et 1100 nm. Tous les photodétecteurs 48 peuvent être adaptés à détecter un rayonnement électromagnétique dans la même plage de longueurs d'ondes. A titre de variante, les photodétecteurs 48 peuvent être adaptés à détecter un rayonnement électromagnétique dans des plages de longueurs d'ondes différentes.

Le système d'acquisition d'images 40 comprend, en outre, des moyens non représentés de traitement des signaux fournis par le capteur d'images 44, comprenant par exemple un microprocesseur.

Le filtre angulaire 5, recouvrant le capteur d'images 44, est adapté à filtrer le rayonnement incident 42 en fonction de l'incidence du rayonnement 42 par rapport à la face supérieure 22, notamment pour que chaque photodétecteur 48 reçoive seulement les rayons dont l'incidence par rapport à un axe perpendiculaire à la face supérieure 22 est inférieure un angle d'incidence maximale inférieur à 45°, de préférence inférieur à 30°, plus préférentiellement inférieur à 20°, encore plus préférentiellement inférieur à 10°. Le filtre angulaire 5 est adapté à bloquer les rayons du rayonnement incident dont l'incidence par rapport à un axe perpendiculaire à la face supérieure 22 est supérieure à l'angle d'incidence maximale.

Selon un mode de réalisation, les photodétecteurs 48 peuvent être répartis en rangées et en colonnes. En figure 5, le pas des photodétecteurs 48 est le même que le pas des trous 26. La couche à ouvertures 10 est alors de préférence alignée avec le capteur d'images 44 de façon que chaque trou 26 soit en regard d'un photodétecteur 48. Selon un autre mode de réalisation, le pas p des trous 26 est plus petit que le pas des photodétecteurs 48 du capteur d'image 44. Dans ce cas, plusieurs trous 26 peuvent se trouver en regard d'un même photodétecteur 48. Selon un autre mode de réalisation, le pas p des trous 26 est plus grand que le pas des photodétecteurs 48 du capteur d'image 44. Dans ce cas, plusieurs photodétecteurs 48 peuvent se trouver en regard d'un même trou 26.

Un autre exemple d'application du système optique 5 va maintenant être décrit pour un dispositif de collimation d'un système d'éclairage ou d'affichage.

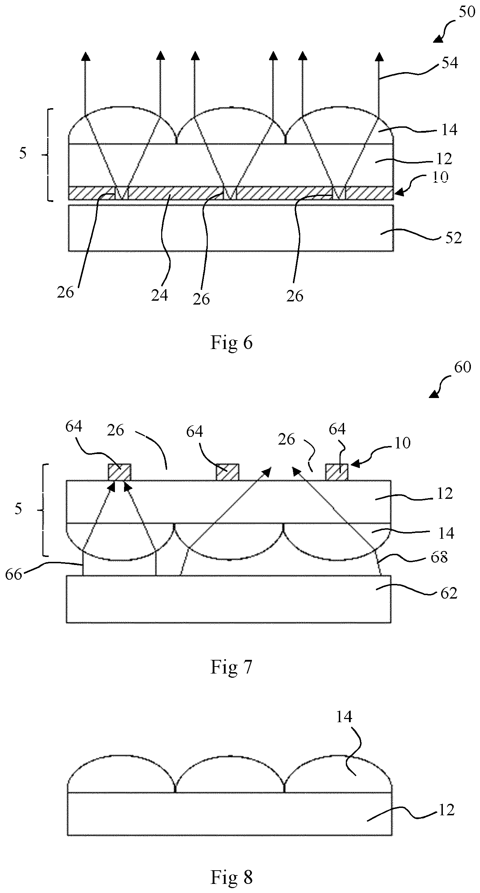

La figure 6 est une vue en coupe, partielle et schématique, d'un mode de réalisation d'un système d'éclairage 50 fournissant une lumière collimatée. Le système d'éclairage 50 comprend, du bas vers le haut en figure 6 :

- une source lumineuse 52 émettant un rayonnement 54 non collimaté ; et
- le système optique 5 tel que décrit précédemment, recouvrant la source lumineuse 52 et recevant le rayonnement 54 fourni par la source lumineuse 52, le revêtement 16 n'étant pas présent en figure 6, la couche à ouvertures 10 étant interposée entre la source lumineuse 52 et la matrice de microlentilles 14.

De préférence, le plan d'émission de la source lumineuse 52 est proche du plan focal du système optique 5.

De plus, selon l'application envisagée, le facteur de forme (rapport hauteur sur largeur) des trous 26 de la couche 10 doit être assez élevé pour qu'aucun rayon sortant d'une ouverture 26 en regard d'une microlentille 14 donnée ne traverse une microlentille voisine. En effet, dans ce cas, le rayon sortant ne serait pas collimaté. Comme mentionné précédemment, l'angle d'ouverture de la couche 10 peut être ajusté par le rapport de forme des ouvertures 26.

Dans le présent mode de réalisation, le système optique 5 joue le rôle d'un dispositif de collimation qui permet de collimater le rayonnement 54 fourni par la source lumineuse 52. En figure 6, la source lumineuse 52 est représentée avec une surface émissive sensiblement plane. A titre de variante, la surface émissive de la source lumineuse 52 peut être courbe.

Un autre exemple d'application du système optique 5 va maintenant être décrit pour un dispositif d'écrantage d'un système d'éclairage.

La figure 7 est une vue en coupe, partielle et schématique, d'un mode de réalisation d'un système d'éclairage 60. Le système d'éclairage 60 comprend, du bas vers le haut en figure 7 :

- une source lumineuse 62 émettant un rayonnement ; et
- le système optique 5 tel que décrit précédemment, recouvrant la source lumineuse 62 et recevant le rayonnement émis par celle-ci, le revêtement 16 n'étant pas présent en figure 7, la matrice de microlentilles 14 étant interposée entre la source lumineuse 62 et la couche à ouvertures 10.

Dans le présent mode de réalisation, la couche à ouvertures 10 comprend des plots opaques 64, chaque plot 64 étant situé en vis-à-vis d'une microlentille 14 et étant entouré par un trou 26, les trous 26 communiquant les uns avec les autres. Dans le présent mode de réalisation, le système optique 5 joue le rôle d'un écran configuré pour bloquer les rayons 66 émis par la source lumineuse 62 de façon sensiblement perpendiculaire par rapport à la face d'émission de la source lumineuse 62 et laisse passer les rayons 68 inclinés par rapport à la surface d'émission de la source lumineuse 62. Un tel système d'éclairage 60 peut être utilisé notamment en microscopie où un éclairage en lumière diffuse peut être souhaitable.

Un autre exemple d'application du système optique 5 comprend l'utilisation du système optique 5 comme masque dans un procédé de photolithographie.

Les figures 8 à 12 sont des vues en coupe, partielles et schématiques, de structures obtenues à des étapes successives d'un mode de réalisation d'un procédé de fabrication du système optique 5 représenté sur les figures 1 et 2.

La figure 8 représente la structure obtenue après la formation de la matrice de microlentilles 14 sur la couche intermédiaire 12. A titre de variante, la matrice de microlentilles 14 peut être formée sur un support différent de la couche intermédiaire 12, ce support étant retiré avant la formation de la couche intermédiaire 12 lorsque la couche intermédiaire 12 est présente, ou avant la formation de la couche à ouvertures 10 lorsque la couche intermédiaire 12 n'est pas présente. Selon un mode de réalisation, la fabrication des microlentilles 14 comprend la formation d'une couche du matériau composant les microlentilles 14 sur la couche intermédiaire 12 ou un autre support et la déformation de cette couche, par exemple au moyen d'une matrice pour former les microlentilles. Selon un autre mode de réalisation, les microlentilles 14 sont formées par moulage.

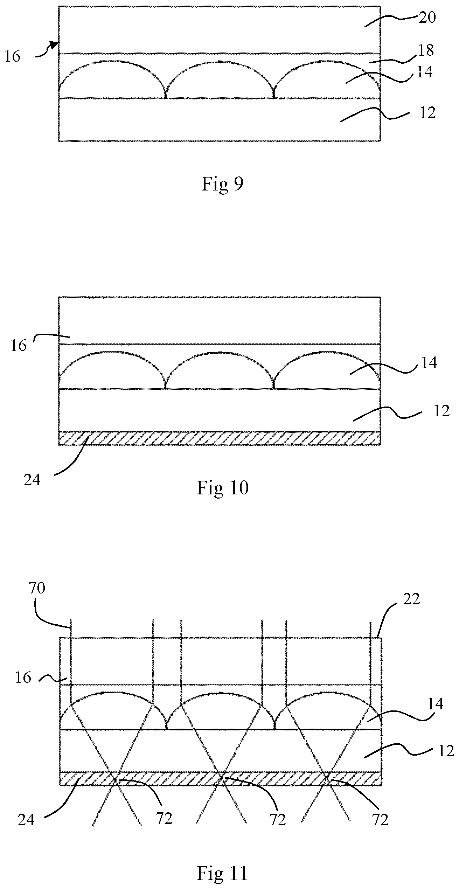

La figure 9 représente la structure obtenue après la formation du revêtement 16 sur la matrice de microlentilles 14 lorsque ce revêtement 16 est présent. Lorsque le revêtement 16 n'est pas présent, les étapes décrites par la suite en relation avec la figure 10 peuvent être réalisées directement après les étapes décrites précédemment en relation avec la figure 8. Selon un mode de réalisation, la formation du revêtement 16 peut comprendre les étapes suivantes :

- déposer une couche liquide ou visqueuse du matériau composant la couche 18 sur la matrice de microlentilles 14. La couche liquide épouse ainsi la forme des microlentilles 14. Cette couche est de préférence autoplanarisante, c'est-à-dire qu'elle forme de façon automatique une face libre sensiblement plane ;

- faire durcir la couche liquide pour former la couche 18. Ceci peut comprendre une étape de réticulation du matériau composant la couche 18, notamment par réticulation thermique et/ou par irradiation par un faisceau ultraviolet ; et

- former la couche 20 sur la couche 18, ou au contact de la couche de microlentilles 14 lorsque la couche 18 n'est pas présente, par exemple par laminage d'un film sur la couche 18.

La figure 10 représente la structure obtenue après la formation de la couche opaque 24 sur la couche intermédiaire 12, du côté opposé à la matrice de microlentilles 14. La couche opaque 24 peut être déposée par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Selon le procédé de dépôt mis en oeuvre, une étape de séchage du matériau déposé peut être prévue.

La figure 11 représente la structure obtenue au cours d'une étape d'exposition à un rayonnement 70, passant au travers des microlentilles 14 de parties 72 de la couche opaque 24 aux emplacements souhaités des trous 26. Le rayonnement utilisé pour exposer la couche opaque 24 dépend de la résine photosensible utilisée. A titre d'exemple, le rayonnement 70 est un rayonnement de longueurs d'onde comprises approximativement entre 300 nm et 450 nm dans le cas d'une résine DNQ-Novolaque ou un rayonnement ultraviolet pour une résine photosensible DUV. La durée de l'exposition de la couche opaque 24 au rayonnement 70 dépend notamment du type de résine photosensible positive utilisée et est suffisante pour que les parties 72 exposées de la couche opaque 24 s'étendent sur toute l'épaisseur de la couche opaque 24.

L'exposition de la couche opaque 24 est réalisée au travers des microlentilles 14. La couche opaque 24 est alors de préférence située dans le plan focal des microlentilles 14 ou à proximité du plan focal des microlentilles 14. Selon un mode de réalisation, le rayonnement incident 70 qui atteint les microlentilles 14 est un rayonnement sensiblement collimaté de sorte qu'il est focalisé par chaque microlentille 14 sensiblement au niveau de la couche opaque 24 ou à proximité de la couche opaque 24. La couche opaque 24 peut être décalée par rapport au plan focal des microlentilles 14 de façon à obtenir des taches de dimensions souhaitées sur la couche opaque 24 lorsque la couche opaque 24 est exposée à un rayonnement 70 au travers des microlentilles 14. De préférence, l'inclinaison du rayonnement 70 par rapport à la face supérieure 22 correspond sensiblement à l'inclinaison moyenne que forme le rayonnement 6 capté par les photodétecteurs 48 avec la face supérieure 22 lors d'une utilisation normale du système d'acquisition d'image 5. Selon un mode de réalisation, le rayonnement 70 est sensiblement perpendiculaire à la couche 24. Selon un autre mode de réalisation, le rayonnement 70 est incliné par rapport à une direction perpendiculaire à la couche 24 permettant ainsi d'obtenir des trous 26 décalées par rapport aux microlentilles. En figure 11, les trous 26 sont cylindriques, c'est-à-dire que leur section droite est constante. Toutefois, comme cela a été décrit précédemment, la section droite des trous 26 peut ne pas être constante. A titre d'exemple, les trous 26 peuvent avoir une forme tronconique. Selon un autre mode de réalisation, le rayonnement incident 70 présente une divergence, par exemple avec un angle de divergence supérieur à 1°, l'angle de divergence du rayonnement incident 70 qui atteint les microlentilles 14 étant alors ajusté pour moduler la largeur des trous 26 réalisés dans la couche 24.

Selon un autre mode de réalisation, notamment lorsque le revêtement 16 n'est pas présent, une couche d'un matériau d'indice de réfraction adapté peut être disposée de façon temporaire sur la matrice de microlentilles 14 pendant l'étape d'exposition pour modifier la distance focale des microlentilles 14 afin que les parties exposées 72 aient les dimensions souhaitées.

Selon un mode de réalisation, la source lumineuse émettant le rayonnement d'exposition 70 peut être déplacée par rapport à la matrice de microlentilles 14 au cours de l'étape d'exposition en fonction de la forme souhaitée des trous 26. A titre d'exemple, la source lumineuse émettant le rayonnement d'exposition 70 peut être déplacée selon une boucle, ce qui permet d'obtenir des trous 26 de section droite annulaire. De telle forme de trous permet notamment la réalisation d'un filtre angulaire passe-bande autorisant le passage de rayons dont l'incidence par rapport à une direction orthogonale à la face 22 est dans au moins une première plage d'incidences et à laisser passer des rayons dont l'incidence par rapport à une direction orthogonale à la face 22 est dans au moins une deuxième plage d'incidences distincte de ladite au moins une première plage d'incidences.

Selon un mode de réalisation, les microlentilles 14 peuvent présenter des points de focalisation différents selon la longueur d'onde du rayonnement d'exposition 70. La couche 24 en résine photosensible peut être sensible à ces différentes longueurs d'onde. A titre de variante, lorsque la couche à ouvertures 10 comprend un empilement de plusieurs couches photosensibles, chaque couche photosensible peut être sensible à un rayonnement à une longueur d'onde particulière. L'étape d'exposition peut alors comprendre l'exposition de la couche photosensible ou des couches photosensibles aux rayonnements à ces différentes longueurs d'onde pour obtenir des trous 26 de forme souhaitée.

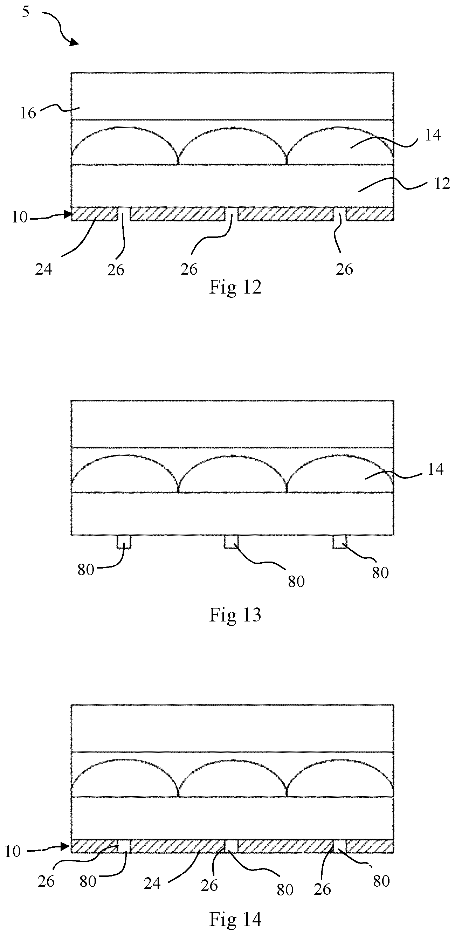

La figure 12 représente la structure obtenue au cours d'une étape de révélation de la couche opaque 24 qui a entraîné la dissolution, dans un révélateur, des parties 72 de la couche opaque 24 exposées au rayonnement 70 incident, formant ainsi les trous 26. La couche à ouvertures 10 est ainsi obtenue. La composition du révélateur dépend de la nature de la résine photosensible positive qui a été utilisée.

Le procédé peut comprendre des étapes ultérieures comprenant le remplissage des trous 26 par un matériau de remplissage et la fixation du système optique 5 ainsi obtenu au capteur d'images 44.

Les figures 13 et 14 sont des vues en coupe, partielles et schématiques, de structures obtenues à des étapes successives d'un autre mode de réalisation d'un procédé de fabrication du système optique 5 représenté sur les figures 1 et 2.

Les étapes initiales du présent mode de réalisation du procédé de fabrication comprennent les étapes décrites précédemment en relation avec les figures 8 à 11 à la différence que la couche 24 est remplacée par une couche du matériau destiné à remplir les trous 26 de la couche à ouvertures 10 et est réalisée en une résine photosensible négative qui est, en outre, transparente au rayonnement utile.

La figure 13 représente la structure obtenue au cours d'une étape de révélation de la couche de résine photosensible négative qui a entraîné la dissolution, dans un révélateur, des parties de la couche en résine photosensible négative qui n'ont pas été exposées au rayonnement 70 utilisé à l'étape d'exposition, les parties de la couche en résine photosensible négative exposées à l'étape d'exposition formant ainsi des plots 80. La composition du révélateur dépend de la nature de la résine photosensible négative qui a été utilisée.

La figure 14 représente la structure obtenue après la formation de la couche opaque 24 entre les plots 80, par exemple par dépôt à la tournette, revêtement par pulvérisation, héliographie, revêtement par filière (en anglais slot-die coating), revêtement à la lame (en anglais blade-coating), flexographie ou sérigraphie. Les plots 80 délimitent ainsi les trous 26 dans la couche 24. La couche à ouvertures 10 est donc ainsi obtenue.

Un autre mode de réalisation d'un procédé de fabrication du système optique 5 représenté sur les figures 1 et 2 comprend les étapes décrites précédemment en relation avec les figures 8 à 11 à la différence que la couche 24 est en un matériau susceptible de se dégrader sous l'action du rayonnement 70 notamment lorsque le rayonnement 70 correspond à un rayonnement laser. L'éclairement de ce rayonnement laser est suffisamment faible pour ne pas endommager la matrice d'éléments optiques de taille micrométrique 14 et suffisamment élevé après collimation par la matrice d'éléments optiques de taille micrométrique 14 pour dégrader la couche 24 au niveau des parties 72. A l'étape d'exposition décrite précédemment en relation avec la figure 11, les parties 72 exposées au rayonnement 70 sont donc détruites par ce rayonnement formant alors directement les trous 26. La couche à ouvertures 10 est donc ainsi obtenue.

Selon un mode de réalisation, le procédé de fabrication du système optique peut correspondre à un procédé bobine à bobine (en anglais roll to roll). Selon un autre mode de réalisation, le procédé de fabrication du système optique peut correspondre à un procédé feuille à feuille.

Lorsque la couche à ouvertures 10 comprend un empilement d'au moins deux couches 24, 28 comprenant chacune des trous 26, 30, comme cela est représenté en figure 4, la première couche 24 avec les trous 26 est réalisée dans un premier temps et la deuxième couche 28 avec les trous 30 est réalisée dans un deuxième temps, en tenant compte de la présence de la première couche 24, selon l'un quelconque des modes de réalisation de procédé de fabrication décrits précédemment. Une couche intermédiaire transparente peut être présente entre les couches 24 et 28.

De façon avantageuse, l'alignement des trous 26 par rapport aux microlentilles 14 est obtenu de façon automatique par le procédé même de formation des trous 26. En outre, lorsque la couche à ouvertures 10 comprend un empilement d'au moins des première et deuxième couches opaques comprenant chacune des trous, l'alignement des trous de la deuxième couche opaque par rapport aux trous de la première couche opaque est obtenu de façon automatique par le procédé même de formation des trous de la deuxième couche opaque.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Procédé de fabrication d'un système optique (5) comprenant les étapes suivantes :

   former une structure constituée d'une matrice de microlentilles (14) sur une première couche (12) ;
   former une deuxième couche (24), opaque à un premier rayonnement sur la face de la première couche opposée à la matrice de microlentilles, ladite deuxième couche sensible à un deuxième rayonnement ;
   exposer ladite deuxième couche au deuxième rayonnement au travers des microlentilles de façon à obtenir des ouvertures (26) traversantes dans la deuxième couche.

2. Système optique (5) comprenant :

   une face (22) destinée à recevoir un premier rayonnement (42, 54) ;
   une matrice de microlentilles (14) ;
   une première couche (12) ;
   une deuxième couche (24) comprenant des ouvertures traversantes (26), la deuxième couche étant opaque à un premier rayonnement mais sensible à un deuxième rayonnement.

3. Procédé selon la revendication 1, ou système selon la revendication 2, dans lequel la deuxième couche (24) est en une résine photosensible positive au deuxième rayonnement, les parties (72) retirées étant les parties exposées au deuxième rayonnement.

4. Procédé selon la revendication 1 ou 3, ou système selon la revendication 2 ou 3, dans lequel le deuxième rayonnement est celui d'un faisceau laser.

5. Procédé ou système selon la revendication 4, dans lequel l'éclairement du rayonnement laser est suffisamment faible pour ne pas endommager la matrice de microlentilles (14) et suffisamment élevé après collimation par la matrice de microlentilles pour dégrader la deuxième couche (24).

6. Procédé selon l'une quelconque des revendications 1, 3 à 5, ou système selon l'une quelconque des revendications 2 à 5, dans lequel le premier rayonnement (42, 54) est différent du deuxième rayonnement (70).

7. Procédé selon l'une quelconque des revendications 1, 3 à 6, ou système selon l'une quelconque des revendications 2 à 6, dans lequel les ouvertures (26) sont remplies par un matériau adhésif.

8. Procédé ou système selon la revendication 7, dans lequel le matériau adhésif permet l'assemblage du système optique (5) à un autre dispositif (44).

9. Procédé selon l'une quelconque des revendication 1, 3 à 8, ou système selon l'une quelconque des revendications 2 à 8, comprenant autant de microlentilles (14) que d'ouvertures (26), le pas entre les éléments optiques de taille micrométrique étant le même que le pas entre les trous.

10. Procédé selon l'une quelconque des revendication 1, 3 à 9, ou système selon l'une quelconque des revendications 2 à 9, dans lequel, pour chaque ouverture (26), le rapport entre la hauteur et la largeur de l'ouverture est compris entre 1 et 10.

11. Procédé selon l'une quelconque des revendication 1, 3 à 10, ou système selon l'une quelconque des revendications 2 à 10, dans lequel le pas (p) entre des ouvertures (26) adjacentes est compris entre 1 $\mu$m et 100 $\mu$m.

12. Procédé ou système selon la revendication 11, dans lequel le pas (p) entre des ouvertures (26) adjacentes est d'environ 15 $\mu$m.

13. Procédé selon l'une quelconque des revendication 1, 3 à 12, ou système selon l'une quelconque des revendications 2 à 12, dans lequel la hauteur de chaque ouverture est comprise entre 1 $\mu$m et 100 $\mu$m.

14. Procédé selon l'une quelconque des revendication 1, 3 à 13, ou système selon l'une quelconque des revendications 3 à 13, dans lequel la largeur de chaque ouverture (26) est comprise entre 0,1 $\mu$m et 100 $\mu$m.

15. Procédé ou système selon la revendication 12, dans lequel la largeur (W) de chaque ouverture (26) trou est de l'ordre de 2 $\mu$m.

16. Procédé selon l'une quelconque des revendication 1, 3 à 15, ou système selon l'une quelconque des revendications 2 à 15, dans lequel les microlentilles (14) sont à base hexagonale.

17. Système d'acquisition d'images comprenant un capteur d'images (44) et un système optique (5) selon l'une quelconque des revendications 2 à 15 recouvrant le capteur d'images et formant un filtre angulaire.

22 5 20 16 18 14 12 10 h

26 24 26 26

Fig 1

26 24 10

w

26

26

p

Fig 2

5 16 18 14

Fig 3

Fig 4

Fig 5

Fig 6

Fig 7

Fig 8

Fig 9

Fig 10

Fig 11

5

16

14

12

10

24   26   26   26

Fig 12

14

80   80   80

Fig 13

14

10

26  80   24  26   80  26   80

Fig 14

**EP 4 235 601 A2**

**RÉFÉRENCES CITÉES DANS LA DESCRIPTION**

**Documents brevets cités dans la description**

- FR 1856709